# EUROPEAN PATENT APPLICATION

(11) **EP 2 573 801 A1**
(43) Date of publication of application: **27.03.2013**
(21) Application number: 11783538.9
(22) Date of filing: 17.05.2011
(51) Int. Cl.: H01L 21/306, H01L 21/308, H01L 31/04

(54) **ETCHING SOLUTION, AND METHOD FOR PROCESSING SURFACE OF SILICON SUBSTRATE**

(30) Priority: 26.10.2010 JP 2010239923; 18.05.2010 JP 2010114615
(71) Applicant: Shinryo Corporation, Fukuoka 806-0021 (JP)
(72) Inventor: SAWAI, Takeshi, Kitakyushu-shi Fukuoka 806-0021 (JP); ISHIKAWA, Makoto, Kitakyushu-shi Fukuoka 806-0021 (JP); SHIRAHAMA, Toshiki, Kitakyushu-shi Fukuoka 807-0811 (JP); OTSUBO, Hiroshi, Kitakyushu-shi Fukuoka 807-0811 (JP)
(74) Representative: Winter, Brandl, Fürniss, Hübner, Röss, Kaiser, Polte - Partnerschaft
(86) International application number: PCT/JP2011/061293
(87) International publication number: WO 2011/145604

(57) **Abstract**

Disclosed is an etching solution which enables the formation of a silicon substrate having fine pyramid-like depressions and protrusions (a textured structure) in a steady manner without requiring the use of any conventional etching inhibitor such as isopropyl alcohol. Specifically disclosed is an etching solution in which a silicon substrate is to be immersed to form pyramid-like depressions and protrusions on the surface of the substrate, and which is characterized by comprising at least one component selected from compounds (A) each represented by general formula (1) and alkali salts thereof and an alkali hydroxide (B) at a concentration of 0.1 to 30 wt% inclusive. (In the formula, R represents one of an alkyl group, an alkenyl group and an alkynyl group each having 4 to 15 inclusive of carbon atoms; and X represents a sulfonic acid group.) By using the etching solution, it becomes possible to form a fine textured structure on the surface of a silicon substrate.

## Description

### TECHNICAL FIELD

The present invention relates to an etching solution for forming pyramid-like depressions and protrusions on the surface of a silicon substrate and a method for processing the surface of a silicon substrate using the etching solution.

### BACKGROUND ART

Fine pyramid-like depressions and protrusions, which are referred to as a textured structure, are formed on the surface of a silicon substrate used in a crystal silicon solar cell. By this textured structure, radiated light undergoes multiple reflection on the surface to have an increased opportunity of being incident into the silicon substrate, and is absorbed efficiently into the inside of the solar cell.

A silicon substrate having a textured structure is produced by etching a silicon substrate obtained by slicing a silicon ingot with a wire saw or the like.
The etching of the silicon substrate can be carried out each by wet etching using an alkaline etching solution. This etching proceeds by reaction of the following reaction formulas (1), (2), (3) and the like in the case of being within a sodium hydroxide solution.

Si + 2NaOH + H₂O → Na₂SiO₃ + 2H₂ reaction formula (1)

2Si + 2NaOH + SH₂O → Na₂Si₂O₅ + 4H₂ reaction formula (2)

3Si + 4NaOH + 4H₂O → Na₄Si₃O₈ + 6H₂ reaction formula (3)

Typically, in order to form a textured structure on the surface of a silicon substrate, anisotropic etching is carried out by using an etching solution with controlled etching speed.
The purpose of etching lies in removing a damaged layer in which distortions or damages caused by a slicing process that are present on the surface of a silicon substrate after being sliced which is a source material and in forming a textured structure. Removal of the damaged layer and formation of the textured structure may be carried out using the same solution, or alternatively, in view of productivity, an etching process in two stages using different etching solutions for removal of the damaged layer and formation of the texture may be carried out.
The etching process in two stages is a processing method in which etching for removal of the damaged layer is carried out using an alkaline etching solution having a comparatively larger etching speed and subsequently anisotropic etching is carried out using an etching solution with controlled etching speed as texture etching.
In any of the methods, formation of the textured structure on the surface of the silicon substrate is based on the following mechanism.
The etching speed on the silicon substrate by an aqueous alkaline solution is the largest on the (100) plane of silicon and is the smallest on the (111) plane. For this reason, when the speed of texture etching is inhibited by adding to the aqueous alkaline solution a specific additive (which may hereafter be referred to as "etching inhibitor") that can reduce the etching speed, a crystal plane that is more liable to be etched such as the (100) plane of silicon is preferentially etched, and the (111) plane having a smaller etching speed remains on the surface. This (111) plane has an inclination of about 54 degrees relative to the (100) plane and therefore, pyramid-like depressions and protrusions constituted of the (111) plane and equivalent planes thereof are formed at the final stage of the process.

For etching to remove the damaged layer, a general etching solution made of a strong alkali chemical liquid can be used; however, in texture etching, the etching speed must be controlled by adding the aforementioned etching inhibitor and controlling various conditions such as the solution temperature.

Typically, as an etching solution for texture etching, an etching solution obtained by adding isopropyl alcohol (which may hereafter be referred to as "IPA") as an etching inhibitor to an aqueous solution of sodium hydroxide (NaOH) is used. A method of heating this etching solution to about 60 to 80°C and immersing a silicon substrate of the (100) plane for 10 to 30 minutes has been adopted (for example, see the patent document 1 and the non-patent document 1).
Further, there is disclosed a method of performing texture etching by using an etching solution obtained by adding IPA as an etching inhibitor to an aqueous solution of potassium hydroxide (KOH) after removing the damaged layer by heating a liquid obtained by diluting 45% potassium hydroxide (KOH) with water at 1:1 to 85°C and immersing the silicon substrate for 30 minutes (for example, see the non-patent document 2).

On the other hand, IPA has a high volatility, so that IPA corresponding to the amount of volatilization must be added into the texture etching solution at appropriate times, thereby raising a problem of increase in the cost of etching caused by increase in the amount of IPA consumption. Furthermore, use of a large amount of IPA having a high volatility is not desirable also from the viewpoint of safety and environment protection. Even if an apparatus for collecting the volatilized IPA is attached, there are problems of increase in the cost of fabricating the etching processing equipment and increase in the cost of equipment operation.

For this reason, development of a texture etching solution containing an etching inhibitor serving as a substitute for IPA is carried out. For example, the patent documents 2 and 3 disclose a texture etching solution to which aliphatic carboxylic acid or a salt thereof has been added. Also, the patent document 4 discloses a texture etching solution containing an inorganic salt.
Also, the patent document 5 discloses an etching solution containing a compound having a benzene ring as an etching inhibitor.
Also, the patent document 6 discloses an etching solution containing alkyl sulfonate having 12 carbon atoms (C₁₂H₂₅-O-SO₃Na).

### PRIOR ART DOCUMENTS

### PATENT DOCUMENTS

Patent document 1: Japanese Patent Application Laid-open (JP-A) No. 61-96772
Patent document 2: Japanese Patent Application Laid-open (JP-A) No. 2002-57139
Patent document 3: International Publication No. 06/046601 Pamphlet
Patent document 4: Japanese Patent Application Laid-open (JP-A) No. 2000-183378
Patent document 5: Japanese Patent Application Laid-open (JP-A) No. 2007-258656
Patent document 6: Chinese Patent No. CN10157089

### NON-PATENT DOCUMENTS

Non-Patent document 1: "Uniform Pyramid Formation on Alkaline-etched Polished Monocrystalline (100) Silicon Wafers", Progress in Photovoltaics, Vol.4, 435-438 (1996)
Non-Patent document 2: "EXPERIMENTAL OPTIMIZATION OF AN ANISOTROPIC ETCHING PROCESS FOR RANDOM TEXTURIZATION OF SILICON SOLAR CELLS", CONFERENCE RECORD OF THE IEEE PHOTOVOLTAIC SPECIALISTS CONFERENCE, P303-308 (1991)

### DISCLOSURE OF THE INVENTION

### PROBLEM TO BE SOLVED BY THE INVENTION

According to the method of using aliphatic carboxylic acid disclosed in the patent documents 2 and 3, the source material cost is high and, when neutralization is carried out during the waste liquid processing, the aliphatic carboxylic acid is liberated, thereby raising a problem of inviting the need for separately providing an oil-water separation step and generating a specific odor. Also, there are problems in that the waste liquid processing requires costs, and this may also lead to rise in the production costs.
Also, according to the method of the patent document 4, expensive Na₂CO₃ must be used in order to inhibit the impurity concentration of heavy metals or salts to a needed level. Also, the salt concentration within the system becomes high, and the amount of dissolution of silicate produced as a byproduct in etching the silicon decreases, so that the texture etching solution must be exchanged frequently.

Also, the etching inhibitor containing a compound having a benzene ring of the patent document 5 is inferior in toxicity and biodegradability as compared with compounds having a simple chain structure, and hence is not preferable from the viewpoint of wastewater treatment and environmental protection.

Also, although the patent document 6 discloses addition of alkyl sulfonate having 12 carbon atoms (C₁₂H₂₅-O-SO₃Na), the ester moiety gradually undergoes hydrolysis in a strong alkali environment as described also in the patent document 2, whereby an alcohol having 12 carbon atoms and sodium hydrogensulfate are produced, so that the inherent function as a surfactant cannot be expected for a long term, and a fine textured structure cannot be formed with a good reproducibility. Due to these reasons, it is not preferable to industrially use a surfactant having an ester structure.

As shown above, with respect to conventional etching solutions, as it stands now, an etching solution being capable of forming a fine textured structure on a silicon substrate with a good reproducibility and having a *performance that is industrially satisfactory in view of waste liquid processing and working environment as well has not yet been found out.
Under such circumstances, an object of the present invention is to provide an etching solution capable of forming a silicon substrate having a fine textured structure in a steady manner without requiring the use of any conventional etching inhibitor such as IPA.

### MEANS FOR SOLVING THE PROBLEM

As a result of repeated eager researches in order to solve the aforementioned problems, the present inventors have found out that the following inventions meet the aforementioned object, thereby arriving at the present invention.

In other words, the present invention pertains to the following inventions.
<1> An etching solution in which a silicon substrate is to be immersed to form pyramid-like depressions and protrusions on the surface of the substrate, and which comprises at least one component selected from compound (A) represented by the following general formula (1) and an alkali salt thereof and an alkali hydroxide (B) at a concentration of 0.1 wt% or more and 30 wt% or less.

   [chemical formula 1] R-X (1)

   (In the formula, R represents one of an alkyl group, an alkenyl group, and an alkynyl group each having 4 or more and 15 or less carbon atoms; and X represents a sulfonic acid group.)
<2> The etching solution according to the aforesaid <1>, wherein R in the general formula (1) in the compound (A) is an alkyl group having 5 or more and 12 or less carbon atoms; and the concentration of the alkali hydroxide (B) is 0.5 wt% or more and 20 wt% or less.
<3> The etching solution according to the aforesaid <1> or <2>, wherein the concentration of the compound (A) is within a range of 0.0001 wt% or more and 10 wt% or less.
<4> The etching solution according to any one of the aforesaid <1> to <3>, wherein the alkali hydroxide (B) is sodium hydroxide and/or potassium hydroxide.
<5> The etching solution according to any one of the aforesaid <1> to <4>, further containing a silicate compound (C).
<6> The etching solution according to the aforesaid <5>, wherein the silicate compound (C) is silicate of sodium or potassium.
<7> The etching solution according to the aforesaid <5> or <6>, wherein the concentration of the silicate compound (C) is 10 wt% or less as an Si-converted concentration.
<8> A method for processing the surface of a silicon substrate comprising a step of immersing a silicon substrate into an etching solution as described in any one of the aforesaid <1> to <7>, so as to form pyramid-like depressions and protrusions on the surface of the substrate.

### EFFECTS OF THE INVENTION

When an etching solution of the present invention is used, a fine textured structure suitable for light confinement for use in a solar cell can be formed on the surface of a silicon substrate with a good reproducibility.

### BRIEF EXPLANATION OF DRAWINGS

FIG. 1 is an electron microscope image of the surface of a silicon substrate after etching is carried out using an etching solution of Example 1.
FIG. 2 is an electron microscope photograph of the surface of a silicon substrate after etching is carried out using an etching solution of Example 2.
FIG. 3 is an electron microscope photograph of the surface of a silicon substrate after etching is carried out using an etching solution of Example 3.
FIG. 4 is an electron microscope photograph of the surface of a silicon substrate after etching is carried out using an etching solution of Example 4.
FIG. 5 is an electron microscope photograph of the surface of a silicon substrate after etching is carried out using an etching solution of Example 5.
FIG. 6 is an electron microscope photograph of the surface of a silicon substrate after etching is carried out using an etching solution of Example 6.
FIG. 7 is an electron microscope photograph of the surface of a silicon substrate after etching is carried out using an etching solution of Example 7.
FIG. 8 is an electron microscope photograph of the surface of a silicon substrate after etching is carried out using an etching solution of Example 9.
FIG. 9 is an electron microscope photograph of the surface of a silicon substrate after etching is carried out using an etching solution of Comparative Example 1.
FIG. 10 is an electron microscope photograph of the surface of a silicon substrate after etching is carried out using an etching solution of Comparative Example 2.
FIG. 11 is an electron microscope photograph of the surface of a silicon substrate after etching is carried out using an etching solution of Comparative Example 3.
FIG. 12 is an electron microscope photograph of the surface of a silicon substrate after etching is carried out using an etching solution of Reference Example 1.

### MODE FOR CARRYING OUT THE INVENTION

Hereafter, the present invention will be described in detail.
The present invention relates to an etching solution in which a silicon wafer is to be immersed to form pyramid-like depressions and protrusions (which may be hereafter referred to as "textured structure") on the surface of the substrate, and which comprises at least one component selected from compound (A) represented by the following general formula (1) and an alkali salt thereof and an alkali hydroxide (B) at a concentration of 0.1 wt% or more and 30 wt% or less.

[chemical formula 2] R-X (1)

(In the formula, R represents one of an alkyl group, an alkenyl group, and an alkynyl group each having 4 or more and 15 or less carbon atoms; and X represents a sulfonic acid group.)

In the present invention, the "silicon substrates" include single-crystal silicon substrates and polycrystalline silicon substrates. The etching solution of the present invention is suitable for etching a single-crystal silicon substrate, in particular, a single-crystal silicon substrate having a (100) plane on the surface.

The compound (A) and the alkali salt thereof have an advantage of exhibiting an etching inhibition effect equivalent to or more than that of IPA which is a conventional etching inhibitor and also having a wide applicable concentration range as will be described later. For this reason, by using the etching solution of the present invention, the size and shape of the pyramid-like depressions and protrusions on the surface of the silicon substrate can be controlled to be within a suitable range.
The compound (A) is a compound in which R in the general formula (1) is one of an alkyl group, an alkenyl group, and an alkynyl group each having 4 or more and 15 or less carbon atoms. For example, specifically, butyl(C:4)sulfonic acid, pentyl(C:5)sulfonic acid, hexyl(C:6)sulfonic acid, heptyl(C:7)sulfonic acid, octyl(C:8)sulfonic acid, nonyl(C:9)sulfonic acid, decyl(C:10)sulfonic acid, undecyl(C:11)sulfonic acid, dodecyl(C:12)sulfonic acid, tridecyl(C:13)sulfonic acid, tetradecyl(C:14)sulfonic acid, and pentadecane(C:15)sulfonic acid as compounds having an alkyl group structure;
butene(C:4)sulfonic acid, pentene(C:5)sulfonic acid, hexene(C:6)sulfonic acid, heptene(C:7)sulfonic acid, octene(C:8)sulfonic acid, nonene(C:9)sulfonic acid, decene(C:10)sulfonic acid, undecene(C:11)sulfonic acid, dodecene(C:12)sulfonic acid, tridecene(C:13)sulfonic acid, tetradecene(C:14)sulfonic acid, and pentadecene(C:15)sulfonic acid as compounds having an alkenyl group structure;
butyne(C:4)sulfonic acid, pentyne(C:5)sulfonic acid, hexyne(C:6)sulfonic acid, heptyne(C:7)sulfonic acid, octyne(C:8)sulfonic acid, nonyne(C:9)sulfonic acid, decyne(C:10)sulfonic acid, undecyne(C:11)sulfonic acid, dodecyne(C:12)sulfonic acid, tridecyne(C:13)sulfonic acid, tetradecyne(C:14)sulfonic acid, and pentadecyne(C:15)sulfonic acid as compounds having an alkynyl group structure; and others can be raised as examples.

Here, as the alkali component in the alkali salt of the compound (A), Group I elements and Group II elements can be used. Among these, lithium hydroxide, sodium hydroxide, and potassium hydroxide in particular are suitable because they can be easily obtained and are excellent also in view of costs.

The compound (A) is suitably a compound in which R in the general formula (1) is an alkyl group having 5 or more and 12 or less carbon atoms. Specifically, pentyl(C:5)sulfonic acid, hexyl(C:6)sulfonic acid, heptyl(C:7)sulfonic acid, octyl(C:8)sulfonic acid, nonyl(C:9)sulfonic acid, decyl(C:10)sulfonic acid, undecyl(C:11)sulfonic acid, and dodecyl(C:12)sulfonic acid can be raised as examples.
Among these, particularly from the viewpoint of being capable of obtaining a uniform textured structure, a compound in which R is an alkyl group having 6 or more and 10 or less carbon atoms is preferable. Specifically, they are hexyl(C:6)sulfonic acid, heptyl(C:7)sulfonic acid, octyl(C:8)sulfonic acid, nonyl(C:9)sulfonic acid, and decyl(C:10)sulfonic acid.

The concentration of the compound (A) is selected within a range of an industrially effective etching speed such that a fine textured structure can be formed on the surface of a silicon substrate, and is preferably 0.0001 wt% or more and 10 wt% or less, more preferably 0.0005 wt% or more and 10 wt% or less, still more preferably 0.001 wt% or more and 5 wt% or less.
Within the above range, a fine textured structure can be formed on the surface of the substrate by anisotropic etching of the surface of the substrate.
When the concentration of the compound (A) is less than 0.0001 wt%, there is a fear that the effect of inhibiting the etching may become insufficient. Also, the concentration is too low, so that the management of the concentration within the etching solution is difficult, making it difficult to produce a silicon substrate having a fine textured structure with a good reproducibility. On the other hand, when the concentration is more than 10 wt%, the effect of inhibiting the etching becomes too strong, so that it is not preferable because it requires a long period of time and also the chemical agent costs, the number of times for washing with water, and the waste liquid processing costs increase.

As the alkali hydroxide (B) used in the present invention, hydroxide of a Group I element and hydroxide of a Group II element can be used. For example, lithium hydroxide (LiOH), sodium hydroxide (NaOH), potassium hydroxide (KOH), rubidium hydroxide (RbOH), cesium hydroxide (CsOH), beryllium hydroxide (Be(OH)₂), magnesium hydroxide (Mg(OH)₂), calcium hydroxide (Ca(OH)₂), strontium hydroxide (Sr(OH)₂), barium hydroxide (Ba(OH)₂), ammonium hydroxide (NH₄OH), and the like can be raised as examples, and these can be used either singly or as a mixture of two or more kinds. Among these, lithium hydroxide, sodium hydroxide, and potassium hydroxide in particular are suitable because they can be easily obtained and are excellent also in view of costs. Also, these alkali hydroxides can be used by being mixed in an arbitrary ratio.

In the etching solution of the present invention, the concentration of the alkali hydroxide (B) in the etching solution is essentially 0.1 wt% or more and 30 wt% or less, preferably 0.5 wt% or more and 20 wt% or less.
Within this range, the etching proceeds suitably, and a fine textured structure can be formed on the surface of a silicon substrate. When the alkali concentration is lower than 0.1 wt%, the etching speed is not sufficient, whereas when the concentration is higher than 30 wt%, the etching speed becomes considerably fast, making it difficult to form a texture.

Here, in the etching solution of the present invention, a silicate compound (C) can be contained in addition to the compound (A) and the alkali hydroxide (B).
As the silicate compound (C), specifically, lithium orthosilicate (Li₄SiO₄·nH₂O), lithium metasilicate (Li₂SiO₃·nH₂O), lithium pyrosilicate (Li₆Si₂O₇·nH₂O), lithium metadisilicate (Li₂Si₂O₅·H₂O), lithium metatrisilicate (Li₄Si₃O₈·nH₂O), sodium orthosilicate (Na₄SiO₄·nH₂O), sodium metasilicate (Na₂SiO₃·nH₂O), sodium pyrosilicate (Na₆Si₂O₇·nH₂O), sodium metadisilicate (Na₂Si₂O₅·nH₂O), sodium metatrisilicate (Na₄Si₃O₈·nH₂O), potassium orthosilicate (K₄SiO₄·nH₂O), potassium metasilicate (K₂SiO₃·nH₂O), potassium pyrosilicate (K₆Si₂O₇·nH₂O), potassium metadisilicate (K₂Si₂O₅·nH₂O), and potassium metatrisilicate (K₄Si₃O₈·nH₂O) can be raised as examples.
With respect to these silicate compounds (C), the compound itself may be added into the etching solution for use, or alternatively, a silicate compound obtained as a reaction product by etching a silicon material such as a silicon wafer, a silicon ingot, or a silicon cut powder, or silicon dioxide directly into the alkali hydroxide (B) may be used as the silicate compound (C).
The silicate compound (C) has a function of inhibiting the etching of silicon, so that, by dosing the silicate compound (C) to the etching solution of the present invention, the function of the compound (A) inhibiting the etching can be aided, whereby control of the etching speed suitable for forming the textured structure can be carried out more appropriately.
When the concentration of the silicate compound (C) is too high, the etching speed considerably decreases, and the liquid viscosity increases and moreover deposition of the silicate compound (C) are liable to occur, whereby a normal textured structure cannot be formed on the surface of the substrate, making it difficult to use it as a substrate for a solar cell. For this reason, the silicate concentration in the etching solution is suitably within a range of 10 wt% or less as an Si-converted concentration. Here, the "Si-converted concentration" means a concentration as converted in terms of silicon (Si) atoms contained in the silicate.
Here, the silicate compound (C) is produced also as a byproduct at the time of etching the silicon substrate for a solar cell, so that, by repeated etching operations, the concentration of the silicate compound (C) in the etching solution increases in accordance with the number of processing the silicon substrate. At this time, when the concentration of the silicate compound (C) in the etching solution exceeds 10 wt% as an Si-converted concentration, it is preferable to dilute the solution by replenishing it with other components such as water or to exchange the solutions.

As described above, the etching solution of the present invention contains the compound (A), the alkali hydroxide (B), and the silicate compound (C) within the above concentration ranges (including a case in which the silicate compound (C) is not contained), and each concentration can be suitably set within a range that can form a normal textured structure on the intended surface of a silicon substrate for a solar cell.

Here, the etching solution of the present invention may contain components other than the compound (A), the alkali hydroxide (B), and the silicate compound (C) as other components within a range that does not deteriorate the objects and effects of the present invention.
As such components, a buffering agent, a pH adjusting agent, a viscosity adjusting agent, a surface tension adjusting agent, and the like can be raised as examples.

The etching solution of the present invention can be obtained by dissolving the compound (A) and the alkali hydroxide (B) described above, and the optional silicate compound (C) in accordance with the needs into water serving as a solvent by a conventional method. Here, the temperature for producing the etching solution is 0°C or higher and 100°C or lower, preferably 20°C or higher and 40°C or lower, and typically room temperature.
Here, water serving as a solvent of the etching solution of the present invention is not particularly limited as long as a normal textured structure can be formed; however, water from which impurities have been removed is preferable, and typically ion exchange water or distilled water is suitably used. Specifically, ion exchange water or distilled water having an electric conductivity of 1 mS/cm or lower (in particular, 100 µS/cm or lower) as measured at 25°C is suitable.

Hereafter, a method of forming a textured structure on a silicon substrate by using the etching solution of the present invention will be described.

As the silicon substrate, a single-crystal or polycrystalline silicon substrate made by any production method may be used; however, a single-crystal silicon substrate is preferable, and in particular a single-crystal silicon substrate in which the crystal orientation of the surface is (100) is preferable. This is due to the following reason. As described above, because the etching of the silicon substrate by an aqueous alkali solution is anisotropic etching, a silicon substrate in which the plane direction of the surface is (100) forms a fine textured structure and one having a low reflectivity can be obtained, so that the energy conversion efficiency when the substrate is made into a cell will be high.

With respect to the etching solution of the present invention, the etching method is not particularly limited, so that a fine textured structure can be formed on the surface of a silicon substrate by a process such as immersing the silicon substrate for a predetermined period of time using the etching solution that has been heated and held at a predetermined temperature.

The temperature for using the etching solution is not particularly limited; however, the etching solution can be used in a temperature range of 0°C or higher and 100°C or lower, and a range of 80°C or higher and 100°C or lower is preferable from the viewpoint of etching efficiency. The etching time is not particularly limited, either; however, it is typically 1 minute or more and 120 minutes or less (suitably 20 minutes or more and 40 minutes or less).

A silicon substrate having a fine textured structure on the surface of the silicon substrate can be obtained by a method of processing the surface of the silicon substrate using the above-described etching solution of the present invention.

### EXAMPLES

Hereafter, the present invention will be described in more detail by way of Examples; however, the present invention is not limited to the following Examples as long as the gist thereof is not altered.

### (1) Preparation of etching solution

The composition of the prepared etching solutions is shown in Table 1.
With respect to the etching solutions of Examples 1, 2, 4 to 6, 8, and 9, first a predetermined amount of NaOH (alkali hydroxide (B)) was dissolved into water at room temperature, and thereafter a single-crystal silicon substrate was immersed and dissolved while being heated at 90°C so as to produce a silicate compound (C). For each of the etching solutions, the etching was repeated until the Si-converted concentration in the solution became the concentration shown in Table 1, and thereafter the solution was cooled to room temperature. Subsequently, a sodium salt of the compound (A) shown in Table 1 was added so as to attain the concentration shown in Table 1 and mixed until the solution became homogeneous, whereby each of the etching solutions was fabricated. Here, the amount of dissolved Si was determined by decrease in the weight before and after the etching of the silicon substrate. Also, the Si concentration in the etching solution in which Si had been dissolved was measured by ICP optical emission spectrometry, where the obtained Si concentration showed a good conformity to the value calculated from the aforesaid weights before and after the etching of the silicon substrate.
Here, in Table 1, the concentration of NaOH in the etching solution is a value calculated by assuming the following conditions as a premise for convenience's sake.
Namely, the mode of the silicate compound (C) obtained by the etching was assumed to be "Na₂Si₂O₅" produced by the above-described reaction shown in the reaction formula (2), and a value obtained by subtracting the amount of NaOH consumed by the reaction shown in the reaction formula (2) from the amount of NaOH initially introduced was regarded as the NaOH concentration in the etching solution.
The etching solutions of Examples 3 and 7 and Comparative Example 1 that do not contain the silicate compound (C) were fabricated by adding a sodium salt of the compound (A) shown in Table 1 so as to attain a concentration shown in Table 1 into a solution obtained by dissolving NaOH (alkali hydroxide (B)) at a concentration shown in Table 1 into water at room temperature, and stirring until the sodium salt was completely dissolved.
The etching solution of Comparative Example 2 that does not contain the compound (A) and the silicate compound (C) was fabricated by dissolving NaOH (alkali hydroxide (B)) at a concentration shown in Table 1 into water at room temperature.
The etching solution of Comparative Example 3 that does not contain the compound (A) was fabricated by heating to 90°C a solution obtained by dissolving a predetermined amount of NaOH (alkali hydroxide (B)) into water at room temperature, so as to dissolve the silicon substrate to attain an Si-converted concentration shown in Table 1 to produce the silicate compound (C).
The etching solution of Reference Example 1 was fabricated by using conventional isopropyl alcohol (IPA) instead of the compound (A) as an etching inhibitor and adding NaOH (alkali hydroxide (B)) and IPA into water at room temperature so as to attain a composition shown in Table 1.
The etching solution of Reference Example 2 was fabricated by using IPA instead of the compound (A) as an etching inhibitor, heating to 90°C a solution obtained by dissolving NaOH (alkali hydroxide (B)) into water at room temperature so as to dissolve the silicon substrate to attain an Si-converted concentration shown in Table 1 to produce the silicate compound (C), and thereafter adding a predetermined amount of IPA.

**[TABLE 1]**

| | alkali salt of compound (A) | | | | alkali hydroxide (B) | | silicate compound (C) |
|---|---|---|---|---|---|---|---|
| | substance name | compound (A) | | concentration [wt%] | substance name | concentration [wt%] | Si-converted concentration [wt%] |
| | | R | X | | | | |
| Example 1 | sodium octylsulfonate | C₈H₁₇ | SO₃H | 1.0 | NaOH | 4.0 | 1.0 |
| Example 2 | sodium heptylsulfonate | C₇H₁₅ | SO₃H | 5.0 × 10⁻¹ | NaOH | 1.0 | 3.0 |
| Example 3 | sodium octylsulfonate | C₈H₁₇ | SO₃H | 1.0 | NaOH | 3.0 | - |
| Example 4 | sodium octylsulfonate | C₈H₁₇ | SO₃H | 7.0 × 10⁻¹ | NaOH | 3.0 | 1.0 |
| Example 5 | sodium octylsulfonate | C₈H₁₇ | SO₃H | 3.0 × 10⁻¹ | NaOH | 3.0 | 4.0 |
| Example 6 | sodium decylsulfonate | C₁₀H₂₁ | SO₃H | 3.0 × 10⁻² | NaOH | 3.0 | 1.0 |
| Example 7 | sodium decylsulfonate | C₁₀H₂₁ | SO₃H | 1.0 × 10⁻¹ | NaOH | 3.0 | - |
| Example 8 | sodium octylsulfonate | C₈H₁₇ | SO₃H | 1.0 | NaOH | 4.0 | 1.0 |
| Example 9 | sodium octylsulfonate | C₈H₁₇ | SO₃H | 5.0 × 10⁻¹ | NaOH | 4.7 | 4.4 |
| Comparative Example 1 | sodium dodecylbenzenesulfonate | C₁₂H₂₅C₆H₄ | SO₃H | 5.0 × 10⁻⁴ | NaOH | 3.0 | - |
| Comparative Example 2 | - | - | - | - | NaOH | 3.0 | - |
| Comparative Example 3 | - | - | - | - | NaOH | 3.0 | 1.0 |
| Reference Example 1 | isopropyl alcohol | - | - | 5.0 | NaOH | 1.6 | - |
| Reference Example 2 | isopropyl alcohol | - | - | 4.0 | NaOH | 1.6 | 0.1 |

### (2) Etching of silicon substrate

Table 2 shows processing conditions for forming a textured structure and results such as properties of a silicon substrate for a solar cell obtained in accordance therewith.

### (Example 1, Reference Example 1)

By using a single-crystal silicon substrate (surface crystal plane: (100) plane) sliced by cutting process on a P-type single-crystal silicon ingot and having a size of 50 × 50 mm and a thickness of about 180 µm, immersion into an etching solution having a composition shown in Table 1 was carried out so as to perform texture etching under the conditions shown in Table 2.

### (Examples 2 to 7, Comparative Examples 1 to 3).

Immersion into an etching solution having a composition shown in Table 1 was carried out so as to perform texture etching under the conditions shown in Table 2 in the same manner as in Example 1 except that the substrate was immersed for about 15 minutes into a 25-wt% sodium hydroxide solution heated to 80°C so as to remove the deposit and the process-damaged layer on the surface of the silicon substrate and thereafter wash with water.

### (Example 8)

Immersion into an etching solution having a composition shown in Table 1 was carried out so as to perform texture etching under the conditions shown in Table 2 in the same manner as in Example 1 except that the substrate was immersed for about 10 minutes into a 48-wt% sodium hydroxide solution heated to 80°C so as to remove the adherent substance and the process-denatured layer on the surface of the silicon substrate and thereafter wash with water.

### (Example 9)

Immersion into an etching solution having a composition shown in Table 1 was carried out so as to perform texture etching under the conditions shown in Table 2 in the same manner as in Example 1 except that a silicon substrate having a size of 156 × 156 mm was used.

### (Reference Example 2)

Immersion into an etching solution having a composition shown in Table 1 was carried out so as to perform texture etching under the conditions shown in Table 2 in the same manner as in Example 9 except that the substrate was immersed for about 2 minutes into a 3.5-wt% sodium hydroxide solution heated to 80°C so as to remove the adherent substance and the process-denatured layer on the surface of the silicon substrate and thereafter wash with water.
Here, the etching amount in Table 2 is an etching thickness per one side obtained by measuring the weight of the silicon substrate before and after the texture etching and calculating from the weight difference thereof, and the etching rate denotes the etching speed obtained by dividing the aforesaid etching amount by the etching time.

### (3) Evaluation of silicon substrate after etching

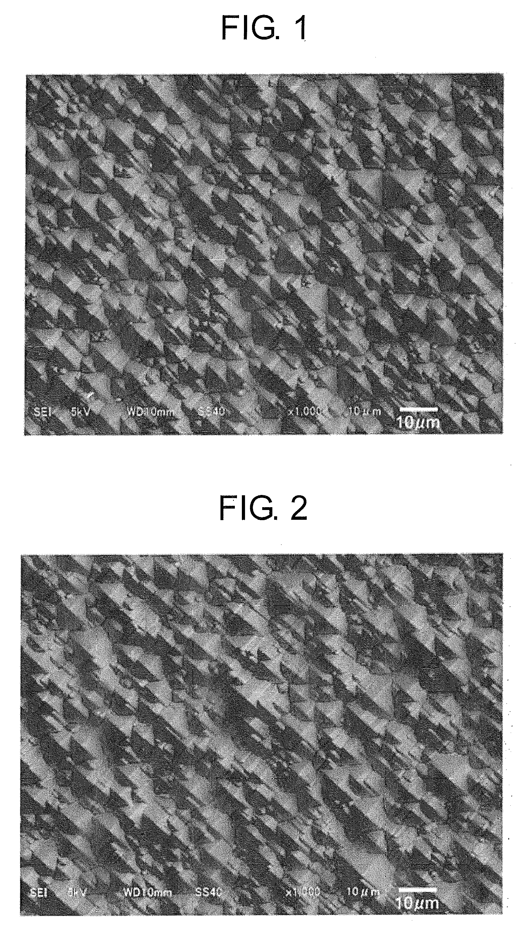

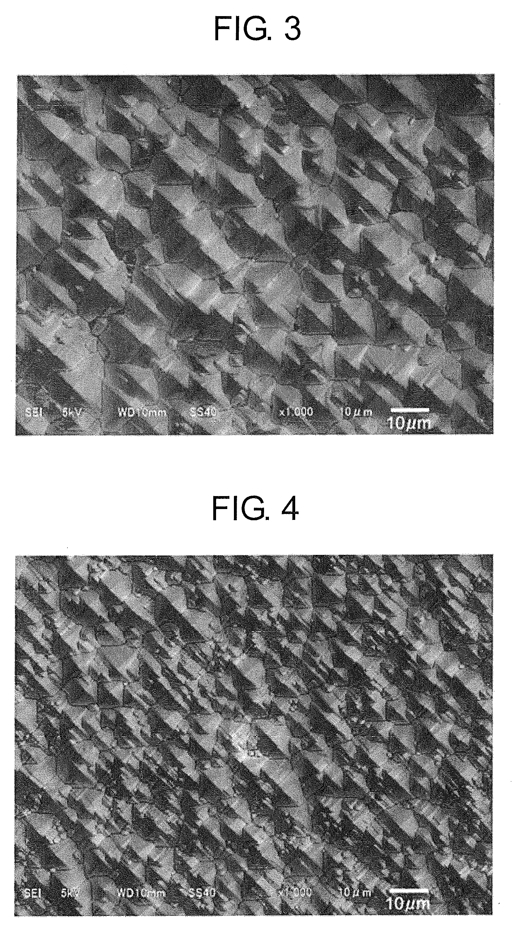

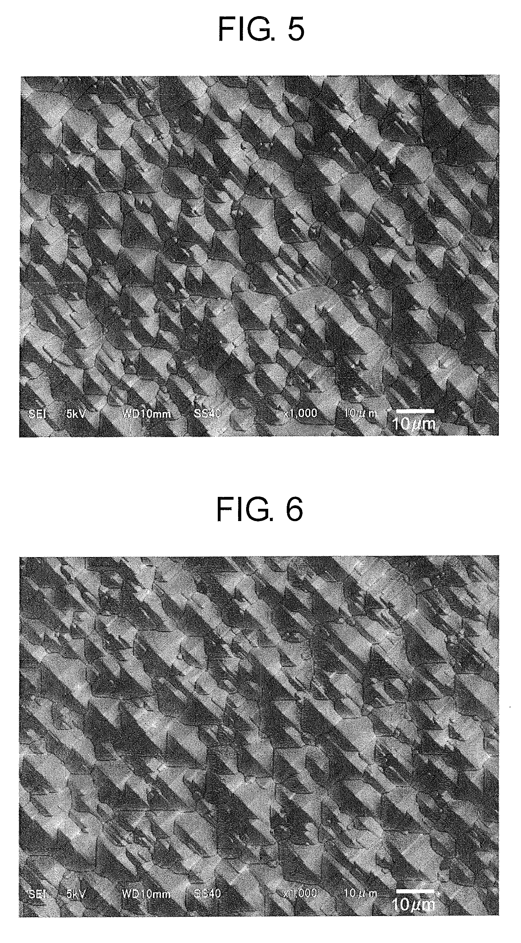

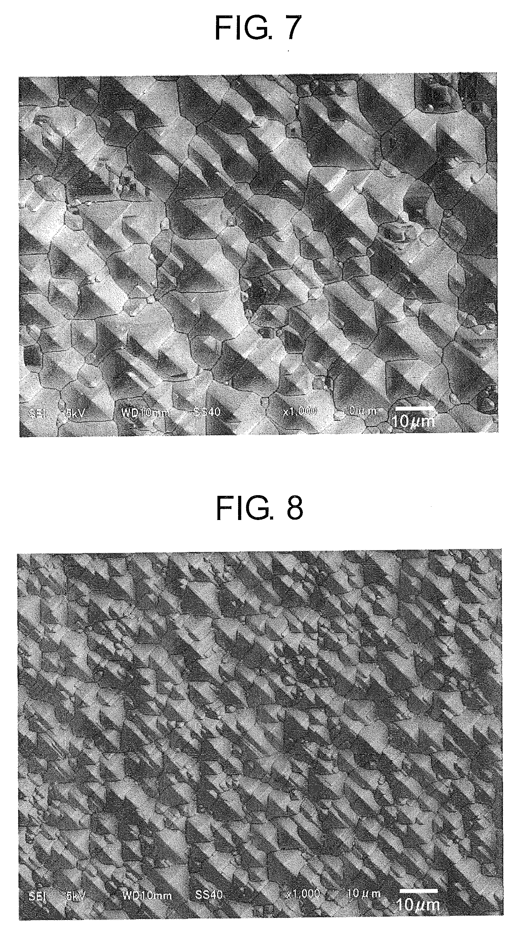

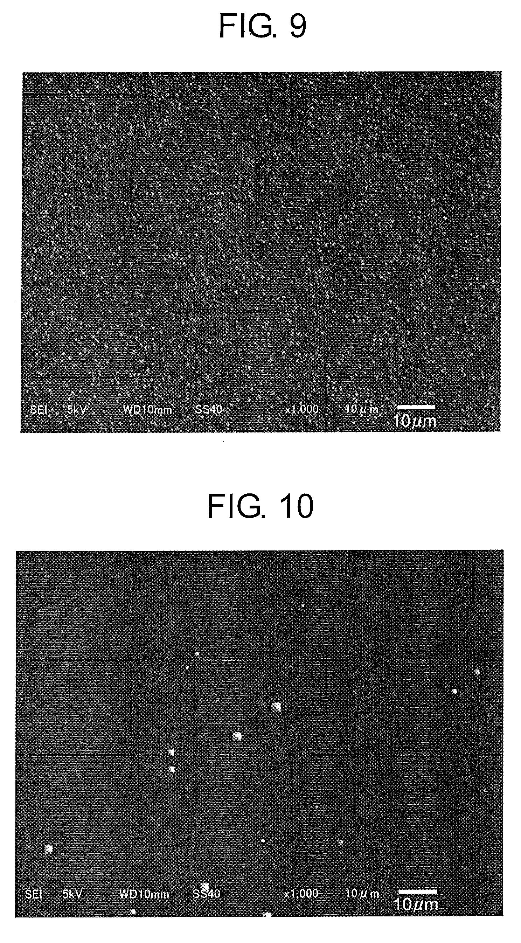

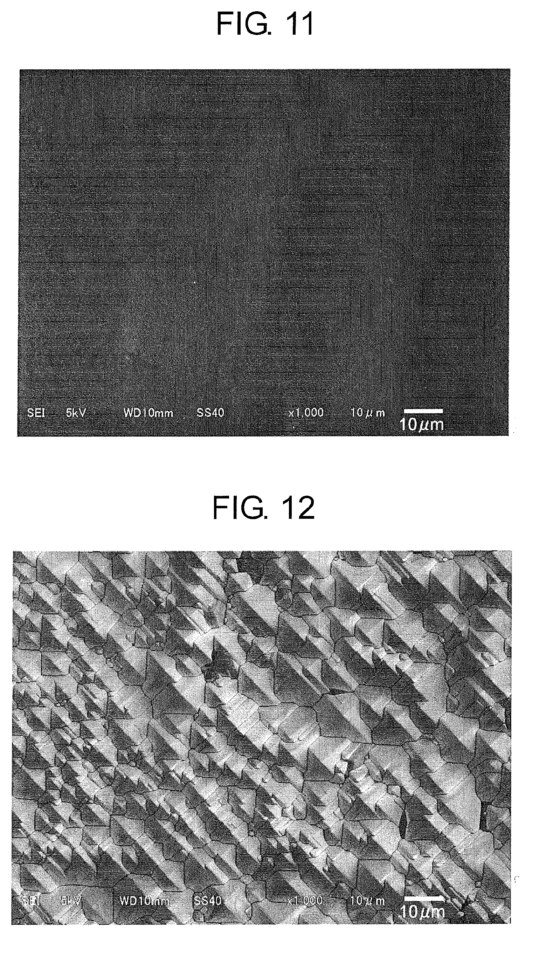

On the silicon substrate after the texture etching, evaluation of the outer appearance by eye inspection, observation by an electron microscope, measurement of surface reflectivity, and measurement of conversion efficiency were carried out. Here, for the observation by an electron microscope, a scanning-type electron microscope (JSM-6510, manufactured by Japan Electron Optics Laboratory Co., Ltd.) was used. For the measurement of surface reflectivity, an UV/VIS/NIR spectrophotometer (UV-3150, manufactured by Shimadzu Corporation) was used.
The evaluation of the outer appearance and the result of reflectivity at a wavelength of 600 nm of each of the silicon substrates are shown in Table 2, and the electron microscope photographs are shown in FIGS. 1 to 12. Here, the standard for evaluation of the outer appearance by eye inspection is as follows.
○: the whole surface of the substrate is uniformly etched.
Δ: the etching uniformity as the whole surface of the substrate is high, though few spots or unevennesses are present.
×: spots or unevennesses are recognized.

Also, regarding the silicon substrates on which texture etching was carried out using the etching solutions of Example 9 and Reference Example 2, a result of measuring the conversion efficiency after fabricating a solar cell is shown together in Table 2. Here, the solar cell used for the measurement was fabricated by the following procedure.
With respect to each of the silicon substrates, an n⁺ layer was formed on the surface of the substrate by using phosphorous oxychloride (POCl₃) as a dopant in a diffusion furnace. Subsequently, after the end surface of the substrate was etched using a corrosive gas excited by plasma so as to perform PN separation, PSG on the surface of the substrate was removed by using hydrofluoric acid, and a silicon nitride film was formed to a thickness of 90 nm by CVD on the surface that would become a photoreception surface. Finally, a comb-shaped grid electrode was formed using a silver paste on the surface that would become the photoreception surface, and a back surface electrode was formed on the back surface of the photoreception surface by printing and applying an aluminum paste or aluminum-silver paste and calcine the resultant at 840°C, whereby a solar cell was obtained.

**[TABLE 2]**

| | substrate size [mm] | etching temperature [°C] | etching time [min] | etching amount [µm] | etching rate [µm/min] | outer appearance | light reflectivity [%] | conversion efficiency (Eff) [%] |
|---|---|---|---|---|---|---|---|---|
| Example 1 | 50 × 50 | 90 | 47 | 9.7 | 0.21 | ○ | 10.8 | - |
| Example 2 | 50 × 50 | 90 | 20 | 10.9 | 0.55 | Δ | 10.9 | - |
| Example 3 | 50 × 50 | 80 | 25 | 10.0 | 0.40 | ○ | 11.9 | - |
| Example 4 | 50 × 50 | 90 | 29 | 10.2 | 0.35 | ○ | 10.4 | - |
| Example 5 | 50 × 50 | 90 | 32 | 10.3 | 0.32 | ○ | 10.9 | - |
| Example 6 | 50 × 50 | 80 | 24 | 10.2 | 0.43 | ○ | 10.9 | - |
| Example 7 | 50 × 50 | 80 | 45 | 10.4 | 0.23 | ○ | 11.9 | - |
| Example 8 | 50 × 50 | 90 | 35 | 9.1 | 0.26 | ○ | 10.7 | - |
| Example 9 | 156 × 156 | 90 | 37 | 11.6 | 0.31 | ○ | 10.9 | 17.1 |
| Comparative Example 1 | 50 × 50 | 80 | 15 | 1.4 | 0.09 | × | 32.2 | - |
| Comparative Example 2 | 60 × 50 | 80 | 15 | 19.6 | 1.30 | × | 33.8 | - |
| Comparative Example 3 | 50 × 50 | 80 | 12 | 15.0 | 1.25 | × | 31.9 | - |
| Reference Example 1 | 50 × 60 | 72 | 40 | 8.2 | 0.21 | Δ | 11.4 | - |
| Reference Example 2 | 156 × 156 | 72 | 60 | 8.8 | 0.15 | Δ | 10.8 | 16.7 |

The uniformity of the outer appearance of the silicon substrate that had been etched using the etching solutions of Examples 1 to 8 was equivalent to or more than that of the case (Reference Example 1) of the conventional etching solution using IPA. Further, by electron microscope observation, it was confirmed that a fine textured structure had been formed on the surface of these silicon substrates. Also, the reflectivity of each had a sufficient value enabling use as a solar cell.
Furthermore, the conversion efficiency of the silicon substrate that had been etched using the etching solution of Example 9 as a solar cell was, as a result, more excellent as compared with the case (Reference Example 2) of the conventional etching solution using IPA.
On the other hand, regarding the etching solution of Comparative Example 1 in which sodium dodecylbenzenesulfonate was used as the sodium salt of the compound (A), the etching speed was extremely slow, and the outer appearance of the substrate after the etching showed a noticable white unevenness. Also, regarding Comparative Examples 2 and 3 in which the compound (A) had not been added, the substrate had an outer appearance that was close to a mirror surface, and a fine textured structure was not confirmed even by electron microscope observation.

### INDUSTRIAL APPLICABILITY

According to the present invention, fine depressions and protrusions can be formed on the surface of a silicon substrate, whereby a higher efficiency of a solar cell using the silicon substrate can be realized, and also reduction of the load imposed upon the environment in view of discharged gas and waste water processing and reduction of the costs can be made, so that it is industrially promising.

## Claims

1. An etching solution in which a silicon substrate is to be immersed to form pyramid-like depressions and protrusions on the surface of the substrate, and which comprises at least one component selected from compound (A) represented by the following general formula (1) and an alkali salt thereof and an alkali hydroxide (B) at a concentration of 0.1 wt% or more and 30 wt% or less.
[chemical formula 1] R-X (1)
(In the formula, R represents one of an alkyl group, an alkenyl group, and an alkynyl group each having 4 or more and 15 or less carbon atoms; and X represents a sulfonic acid group.)

2. The etching solution according to claim 1, wherein R in the general formula (1) in the compound (A) is an alkyl group having 5 or more and 12 or less carbon atoms; and the concentration of the alkali hydroxide (B) is 0.5 wt% or more and 20 wt% or less.

3. The etching solution according to claim 1 or 2, wherein the concentration of the compound (A) is within a range of 0.0001 wt% or more and 10 wt% or less.

4. The etching solution according to any one of claims 1 to 3, wherein the alkali hydroxide (B) is sodium hydroxide and/or potassium hydroxide.

5. The etching solution according to any one of claims 1 to 4, further comprising a silicate compound (C).

6. The etching solution according to claim 5, wherein the silicate compound (C) is silicate of sodium or potassium.

7. The etching solution according to claim 5 or 6, wherein the concentration of the silicate compound (C) is 10 wt% or less as an Si-converted concentration.

8. A method for processing the surface of a silicon substrate comprising a step of immersing a silicon substrate into an etching solution as claimed in any one of claims 1 to 7, so as to form pyramid-like depressions and protrusions on the surface of the substrate.
